# EUROPÄISCHE PATENTSCHRIFT

(11) **EP 3 069 582 B1**
(45) Veröffentlichungstag und Bekanntmachung des Hinweises auf die Patenterteilung: **23.06.2021**
(21) Anmeldenummer: 14798840.6
(22) Anmeldetag: 13.11.2014
(51) Int. Cl.: H05K 1/02, H05K 3/10, H05K 1/18, H05K 1/11, H01C 7/06, G01R 1/20

(54) **LEITERPLATTE MIT WENIGSTENS EINEM EINGEBETTETEN PRÄZISIONSWIDERSTAND**
PRINTED CIRCUIT BOARD WITH AT LEAST ONE EMBEDDED PRECISION RESISTOR
CARTE DE CIRCUIT IMPRIMÉ AVEC AU MOINS UNE RÉSISTANCE DE PRÉCISION INTEGREE

(30) Priorität: 13.11.2013 DE 102013223143
(43) Veröffentlichungstag der Anmeldung: 21.09.2016
(73) Patentinhaber: JUMATECH GmbH, 90542 Eckental (DE)
(72) Erfinder: WÖLFEL, Markus, 90542 Eckenthal (DE)
(74) Vertreter: Grünecker Patent- und Rechtsanwälte PartG mbB
(86) Internationale Anmeldenummer: PCT/EP2014/074506
(87) Internationale Veröffentlichungsnummer: WO 2015/071367

(56) Entgegenhaltungen:
- DE-A1-102008 022 787
- DE-A1-102008 059 694
- DE-A1-102010 009 835
- US-A1- 2004 207 989
- US-A1- 2005 057 865
- Widerstandsbereich: "Widerstände Strommess -Widerstände (Shunt) Serie MST Spezifikation MST-1 MST-2 MST-5", , 1 June 2013 (2013-06-01), XP055448179, Retrieved from the Internet: URL:https://web.archive.org/web/2013092123 0125if_/http://www.megatron.de:80/kategori e/strommesswiderstaende/download/228.html [retrieved on 2018-02-06]

## Beschreibung

Die Erfindung betrifft eine Leiterplatte mit wenigstens zwei Anschlussstellen und wenigstens einem Präzisionswiderstand zur Messung eines zwischen den Anschlussstellen fließenden Stroms.

Derartige Leiterplatten mit einem Präzisionswiderstand als Teil einer Messeinrichtung für den zwischen den Anschlussstellen fließenden Strom sind aus dem Stand der Technik bekannt. Dabei wird der Präzisionswiderstand, der bspw. aus massivem, elektronenstrahlverschweißtem Verbundmaterial aus Kupfer und Widerstandslegierungen besteht, als oberflächenmontierbares Bauteil (SMD) auf eine bestehende Schaltung aufgelötet oder über Bond-Drähte verbunden. Durch eine Spannungsmessung zwischen den Anschlussstellen und aufgrund des bekannten elektrischen Widerstandswerts, der sich aufgrund des äußerst geringen Temperaturkoeffizienten der eingesetzten Materialien im maßgeblichen Temperaturbereich von 20 bis 60°C in der Regel nur geringfügig ändert, kann der zwischen den Anschlussstellen fließende Strom mit hoher Genauigkeit ermittelt werden.

Die Herstellung dieser Leiterplatten ist vergleichsweise komplex und teuer. Die Kontaktierung des Präzisionswiderstands an den Anschlussstellen ist oft auch anfällig gegenüber Vibrationen, was die Lebensdauer der Leiterplatte reduzieren kann. Zudem geht der Trend bei vielen technischen Anwendungen (z.B. Automobil, Smartphone etc.) hin zur Minimierung der Größe ("Downsizing"), was insbesondere den Bauraum der dafür eingesetzten elektrischen Komponenten, wie z.B. Leiterplatten, einschränkt.

DE 10 2008 022787 A1 offenbart eine Leiterplatte zur Messung eines Stroms mit den Merkmalen des Oberbegriffs von Anspruch 1.

US 2004/207989 A1 offenbart einen in eine Leiterplatte eingebetteten Strommesswiderstand.

Der Erfindung liegt demnach die Aufgabe zugrunde, eine Leiterplatte der eingangs genannten Art kostengünstiger herzustellen, so dass die Leiterplatte bei vorzugsweise höherer Lebensdauer einen verringerten Bauraum aufweist.

Die Aufgabe der Erfindung wird gelöst durch die Leiterplatte nach Anspruch 1. Durch die Anordnung des Präzisionswiderstands in der Leiterplatte wird einerseits der Bauraum verringert und andererseits der Herstellungsaufwand sowie die Empfindlichkeit der Leiterplatte gegenüber äußeren Einwirkungen wie Vibrationen deutlich verringert. Dadurch kann die Leiterplatte kostengünstiger, kompakter und langlebiger hergestellt werden als die herkömmlichen Produkte.

Es kann von Vorteil sein, wenn die Leiterplatte wenigstens eine Schicht aus Isolierstoffmasse aufweist, wobei die Dicke der wenigstens einen Schicht aus Isolierstoffmasse vorzugsweise im Bereich von 50 bis 2000 µm, bevorzugt im Bereich von 100 bis 1800 µm, besonders bevorzugt im Bereich von 800 bis 1600 µm liegt.

Es kann sich auch als nützlich erweisen, wenn auf der Leiterplatte Schaltungselektronik und/oder Leistungselektronik angeordnet ist. Die erfindungsgemäße Herstellungstechnik für Leiterplatten eignet sich insbesondere für den Einsatz im Bereich der Schaltungselektronik und/oder Leistungselektronik, da bspw. über in die Leiterplatte eingebettete Leitungsdrähte und/oder Leiter-Formteile große Wärme- und Strommengen beherrschbar sind.

Gemäß einer vorteilhaften Ausführung der Erfindung erfüllt der Präzisionswiderstand wenigstens eine der folgenden Anforderungen:
- Der Präzisionswiderstand umfasst einen Widerstandswert im Bereich von 0.1 bis 300 mOhm, vorzugsweise im Bereich von 1 bis 100 mOhm.
- Der Präzisionswiderstand umfasst eine Varianz von weniger als +/- 5%, vorzugsweise eine Varianz von weniger als +/- 2%, bevorzugt eine Varianz von +/- 1% oder weniger.
- Der Temperaturkoeffizient des elektrischen Widerstandes des Präzisionswiderstands für den Temperaturbereich zwischen 20 und 60 °C liegt im Bereich von 0.1 ppm/K bis 200 ppm/K, vorzugsweise im Bereich von 0.5 ppm/K bis 100 ppm/K, bevorzugt im Bereich von 1 ppm/K bis 50 ppm/K.
- Der Präzisionswiderstand besteht aus Metall, vorzugsweise aus wenigstens einem der Elemente Kupfer (Cu), Mangan (Mn), Nickel (Ni), Chrom (Cr), Aluminium (Al), Silizium (Si) oder Zinn (Sn), bevorzugt aus einer Legierung enthaltend wenigstens eines der Elemente Kupfer (Cu), Mangan (Mn), Nickel (Ni), Chrom (Cr), Aluminium (Al), Silizium (Si) oder Zinn (Sn), beispielsweise aus Manganin, Zeranin oder Isaohm.
- Der Präzisionswiderstand ist zumindest überwiegend, vorzugsweise vollständig, in die Leiterplatte eingebettet.
- Eine Oberseite und/oder eine Unterseite und/oder alle Randseiten des Präzisionswiderstands, ist/sind zumindest abschnittsweise, vorzugsweise vollständig, mit Isolierstoffmasse bedeckt.
- Eine Oberseite und/oder eine Unterseite und/oder wenigstens eine der Randseiten des Präzisionswiderstands verläuft zumindest abschnittsweise, vorzugsweise vollständig, bündig mit einer Oberseite und/oder einer Unterseite und/oder wenigstens einer der Randseiten einer angrenzenden Schicht aus Isolierstoffmasse.
- Die Oberseiten und/oder die Unterseiten und/oder wenigstens jeweils eine der Randseiten der Leiterplatte und des Präzisionswiderstands sind parallel zueinander ausgerichtet.
- Der Präzisionswiderstand ist im Strangpressverfahren herstellbar oder hergestellt.
- Der Präzisionswiderstand ist als Flachdraht ausgebildet.
- Der Präzisionswiderstand erstreckt sich im Wesentlichen in einer Ebene.
- Der Präzisionswiderstand umfasst einen rechteckförmigen Querschnitt, wobei vorzugsweise die Seite des Querschnitts mit der größeren Ausdehnung zur Oberfläche der Leiterplatte weist.
- Der Präzisionswiderstand ist als Formteil aus einem plattenförmigen Werkstück herausgetrennt, vorzugsweise durch Stanzen, Erodieren oder Scheiden, beispielsweise durch Wasserstrahlschneiden, wobei das Formteil bevorzugt im Wesentlichen L-förmig, T-förmig, H-förmig, S-förmig, O-förmig, E-förmig, F-förmig, X-förmig, Y-förmig, Z-förmig, C-förmig, U-förmig oder Ω-förmig ausgebildet ist.
- Der Präzisionswiderstand weist eine Dicke im Bereich von 10 bis 2000 µm, vorzugsweise im Bereich von 50 bis 1000 µm, bevorzugt im Bereich von 100 bis 500 µm auf.

Für den Präzisionswiderstand gibt es verschiedenste Gestaltungsmöglichkeiten, die vom Schutzbereich der Erfindung umfasst sein sollen. Maßgeblich ist, dass der Präzisionswiderstand zwischen den Anschlussstellen in der Leiterplatte verläuft, wobei die Ausgestaltung des Präzisionswiderstands als Leitungsdraht, Flachdraht oder als Formteil aus Kostengründen oder fertigungsbedingt am zweckdienlichsten erscheint. Die Ausgestaltung des Präzisionswiderstands als Leitungsdraht, Flachdraht oder als Formteil hat zudem den Vorteil, dass die Ankontaktierung an den Anschlussstellen über große Kontaktflächen erfolgen kann, so dass über die Kontaktierung nur geringe Leistungsverluste entstehen, die sich nachteilig auf die Strommessung auswirken könnten.

Es kann sich als vorteilhaft erweisen, wenn die Leiterplatte eine Spannungsmesseinrichtung aufweist, die wenigstens eine der folgenden Anforderungen erfüllt:
- Die Spannungsmesseinrichtung ist dazu ausgebildet, eine Spannung an den Anschlussstellen, vorzugsweise an den Kontaktstellen zwischen dem Präzisionswiderstand und den Anschlussstellen, zu messen.
- Die Spannungsmesseinrichtung verwirklicht eine HDI (High Density Interconnect) - Schaltung, vorzugsweise mit wenigstens einem der folgenden Merkmale:
   ∘ Der Präzisionswiderstand und/oder die Anschlussstellen ist/sind von wenigstens einer Schicht aus Isolierstoffmasse bedeckt.
   ∘ Eine Bohrung zur Ankontaktierung des Präzisionswiderstands durch wenigstens eine Schicht aus Isolierstoffmasse ist vorzugsweise als Laserbohrung ausgebildet.
   ∘ Der Präzisionswiderstand ist durch wenigstens eine Schicht aus Isolierstoffmasse, vorzugsweise über Microvias, ankontaktiert.
   ∘ Der Präzisionswiderstand ist galvanisch ankontaktiert.

Die Ausgestaltung der Spannungsmesseinrichtung als HDI (High Density Interconnect) - Schaltung erweist sich als besonders vorteilhaft im Zusammenhang mit besonders niederohmigen Präzisionswiderständen, da die Ankontaktierung sehr präzise erfolgen kann.

Die Aufgabe der Erfindung wird ebenfalls gelöst durch ein Verfahren zur Herstellung einer Leiterplatte gemäß Anspruch 10.

Gemäß einer vorteilhaften Ausführung umfasst das Verfahren wenigstens einen der folgenden Schritte:
- Verpressen des Präzisionswiderstands mit einem Prepreg aus Isolierstoffmasse.
- Herausarbeiten von Leiterbahnen, vorzugsweise für eine Spannungsmesseinrichtung, durch Ätzung aus einer auf der Oberfläche der Leiterplatte befestigten Kupferfolie, wobei die Ätzung der Kupferfolie vorzugsweise nach dem Ankontaktieren des Präzisionswiderstands an den Anschlussstellen erfolgt.
- Herstellen einer Spannungsmesseinrichtung, vorzugsweise durch Verwirklichung einer HDI (High Density Interconnect) - Schaltung auf der Leiterplatte, bevorzugt mit wenigstens einem der folgenden Schritte:
   ∘ Bedecken des Präzisionswiderstands und/oder der Anschlussstellen mit wenigstens einer Schicht aus Isolierstoffmasse.
   ∘ Herstellen einer Bohrung zur Ankontaktierung des Präzisionswiderstands durch wenigstens eine Schicht aus Isolierstoffmasse, vorzugsweise als Laserbohrung.
   ∘ Ankontaktieren des Präzisionswiderstands durch wenigstens eine Schicht aus Isolierstoffmasse, vorzugsweise über Microvias.
   ∘ Galvanisches Ankontaktieren des Präzisionswiderstands.

Weitere vorteilhafte Weiterbildungen der Erfindung ergeben sich durch Kombinationen der in den Ansprüchen, der Beschreibung und den Zeichnungen offenbarten Merkmale.

### Kurze Beschreibung der Figuren

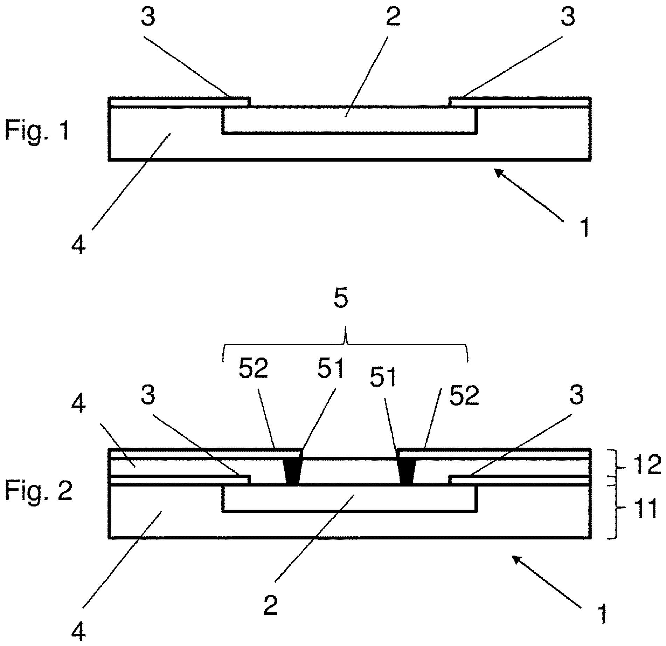

- Fig. 1: zeigt eine schematische Schnittansicht einer Leiterplatte nach dem ersten Ausführungsbeispiel der Erfindung, wobei die Leiterplatte ein Substrat mit einer Schicht aus Isolierstoffmasse und einen darin eingebetteten Präzisionswiderstand in der Größenordnung von 100 mOhm aufweist, wobei Leiterbahnen mit endseitigen Anschlussstellen auf der Oberseite der Leiterplatte verlaufen und die Anschlussstellen mit dem Präzisionswiderstand verschweißt sind.
- Fig. 2: zeigt eine schematische Schnittansicht einer Leiterplatte nach dem zweiten Ausführungsbeispiel der Erfindung, wobei die Leiterplatte ein Substrat mit zwei Schichten aus Isolierstoffmasse und einen in der unteren Schicht eingebetteten Präzisionswiderstand in der Größenordnung von 1 mOhm aufweist, wobei Leiterbahnen mit endseitigen Anschlussstellen zwischen der oberen und unteren Schicht aus Isolierstoffmasse verlaufen und die Anschlussstellen mit dem Präzisionswiderstand verschweißt sind, wobei der Präzisionswiderstand durch die obere Schicht aus Isolierstoffmasse über Leiterbahnen und Microvias zur Bewerkstelligung einer Spannungsmesseinrichtung in Gestalt einer HDI-Schaltung galvanisch ankontaktiert ist.

Die Darstellungen der Leiterplatten in den Figuren sind schematischer Natur. Die Größenverhältnisse zwischen den einzelnen Komponenten der Leiterplatten sind daher möglicherweise nicht realistisch.

### Detaillierte Beschreibung der bevorzugten Ausführungsbeispiele

Die bevorzugten Ausführungsbeispiele der Erfindung werden nachstehend mit Bezug auf die Figuren im Detail beschrieben.

### Erstes Ausführunasbeispiel (Fig. 1)

Das erste Ausführungsbeispiel der Erfindung gemäß Fig. 1 betrifft eine Leiterplatte 1 mit zwei Anschlussstellen 3 und einem Präzisionswiderstand 2 zur Messung eines zwischen den beiden Anschlussstellen 3 fließenden Stroms. Erfindungsgemäß erstreckt sich der Präzisionswiderstand 2 zwischen den Anschlussstellen 3 in der Leiterplatte 1. Die Leiterplatte 1 weist eine Schicht aus Isolierstoffmasse 4 mit einer Dicke von ca. 1000 µm auf, in die der Präzisionswiderstand 2 eingebettet ist. Die Unterseite, alle Randseiten und ein Großteil der Oberseite des Präzisionswiderstands 2 sind vollständig mit Isolierstoffmasse 4 bedeckt. Die Oberseite des Präzisionswiderstands 2 verläuft zumindest abschnittsweise, insbesondere an den mit den Anschlussstellen 3 verbundenen Enden, bündig mit einer Oberseite der umgebenden und angrenzenden Schicht aus Isolierstoffmasse 4.

Auf der Leiterplatte 1 ist bspw. Schaltungselektronik und/oder Leistungselektronik angeordnet (nicht dargestellt). Der mit beiden Anschlussstellen 3 verschweißte Präzisionswiderstand 2 ist als Flachdraht aus Manganin ausgebildet und umfasst einen Widerstandswert von ca. 100 mOhm bei einer Varianz von +/- 5% oder weniger. Der Temperaturkoeffizient des elektrischen Widerstandes des Präzisionswiderstands 2 für den Temperaturbereich zwischen 20 und 60 °C liegt bei ca. 5 ppm/K. Der Querschnitt des als Flachdraht ausgebildeten Präzisionswiderstands 2 ist rechteckförmig bei ca. 100 µm Dicke und ca. 500 µm Breite, wobei die Seite des Querschnitts mit der größeren Ausdehnung zur Oberfläche der Leiterplatte 1 weist. Dadurch ergeben sich an beiden Anschlussstellen 3 große Kontaktflächen zum Präzisionswiderstand 2.

Eine Spannungsmesseinrichtung (nicht dargestellt) ist dazu ausgebildet, eine Spannung an den Anschlussstellen 3 abzugreifen und direkt an den Kontaktstellen zwischen dem Präzisionswiderstand 2 und den Anschlussstellen 3 zu messen. Der Abstand beider Kontaktstellen ist exakt definiert. Durch den bekannten und über den relevanten Temperaturbereich sehr konstanten elektrischen Widerstand des Präzisionswiderstands 2 kann der zwischen den Anschlussstellen 3 fließende Strom sehr genau bestimmt werden.

Ein erfindungsgemäßes Verfahren zur Herstellung der Leiterplatte 1 mit dem sich in der Leiterplatte 1 erstreckenden Präzisionswiderstand 2 zur Messung des zwischen Anschlussstellen 3 fließenden Stroms umfasst folgende Schritte:
Schritt a: Kontaktieren des als Flachdraht ausgebildeten Präzisionswiderstands 2 aus Manganin, der bspw. eine Dicke von ca. 100 µm und eine Breite von 500 µm aufweist, mit einer Kuperfolie, die bspw. eine Dicke von ca. 35 µm aufweist, an vorgegebenen Anschlussstellen 3 durch Verschweißung.

Schritt b: Aufbringen einer Schicht aus Isolierstoffmasse 4 auf die mit dem Präzisionswiderstand 2 verbundene Seite der Folie durch Verpressen mit einem Prepreg aus Isolierstoffmasse.

Schritt c: Herausarbeiten der Anschlussstellen 3 und/oder Herausarbeiten von Leiterbahnen, z.B. für eine Spannungsmesseinrichtung, in einem Arbeitsgang durch Ätzung aus der auf der Oberfläche der Leiterplatte 1 bzw. auf der Schicht aus Isolierstoffmasse 4 befestigten Kupferfolie, um die Anschlussstellen 3 elektrisch voneinander zu isolieren, so dass ein zwischen den Anschlussstellen 3 fließender Strom durch den Präzisionswiderstand 2 fließt.

Im Folgenden werden für ähnliche Elemente dieselben Bezugszeichen verwendet, um eine Wiederholung der Beschreibung zu vermeiden.

### Zweites Ausführungsbeispiel (Fig. 2)

Das zweite Ausführungsbeispiel der Erfindung gemäß Fig. 2 basiert im Wesentlichen auf dem ersten Ausführungsbeispiel, das zuvor im Zusammenhang mit Fig. 1 beschrieben wurde. Die Leiterplatte 1 nach dem zweiten Ausführungsbeispiel der Erfindung ist insbesondere für hochpräzise Strommessungen im niederohmigen Bereich vorgesehen und umfasst zwei Schichten, die im Wesentlichen aus Isolierstoffmasse 4 bestehen. Der Aufbau der unteren Schicht der Leiterplatte 1 des zweiten Ausführungsbeispiels stimmt mit der Leiterplatte 1 des ersten Ausführungsbeispiels im Wesentlichen überein. Die Abmessungen und der Widerstandswert des Präzisionswiderstands 2 sind mit ca. 300 µm Dicke und ca. 1400 µm Breite bzw. 1 mOhm unterschiedlich zum ersten Ausführungsbeispiel. Zur Spannungsmessung wird daher eine anders gestaltete Spannungsmesseinrichtung 5 eingesetzt, wie im Folgenden beschrieben wird.

Die untere Schicht 11 der Leiterplatte 1 ist mit einer Schicht aus Isolierstoffmasse 4 überzogen, die den Präzisionswiderstands 2 und die Anschlussstellen 3 bedeckt. Auf der Oberseite der oberen Schicht 12 der Leiterplatte 1 bzw. der oberen Schicht aus Isolierstoffmasse 4, die eine Dicke von vorzugsweise ca. 100 µm aufweist, ist ein Leiterschaltbild mit entsprechenden Anschlüssen 52 an die Microvias 51 zur Spannungsmessung nach dem zuvor beschriebenen Schema aus einer Kupferfolie mit einer Dicke von vorzugsweise ca. 18 µm durch Ätzung herausgearbeitet. Die Spannungsmesseinrichtung 5 verwirklicht eine HDI High Density Interconnect - Schaltung, wobei Laserbohrungen zur Ankontaktierung des Präzisionswiderstands 2 durch die obere Schicht aus Isolierstoffmasse 4 eingearbeitet sind. Über diese Bohrungen wird der Präzisionswiderstand 2 unter Verwendung von Microvias 51 galvanisch ankontaktiert. Der Abstand der Microvias 51 ist exakt definiert, so dass über die Länge des dazwischen liegenden Präzisionswiderstands 2 der Widerstandswert präzise bestimmt werden kann. Über die Spannungsmessung in Verbindung mit dem präzise bestimmten Widerstandswert kann der zwischen den Anschlussstellen 52 bzw. Microvias 51 fließende Strom exakt errechnet werden.

Die Erfindung ist nicht auf die obigen Ausführungsbeispiele beschränkt. Weitere Vorteilhafte Weiterbildungen der Erfindung ergeben sich insbesondere durch die zusätzliche Verwendung von in die Leiterplatte eingebetteten Leitungsdrähten oder Formteilen, vorzugsweise in Kombination mit geätzten Leiterbahnen. Dadurch können elektronische Baugruppen auf der Leiterplatte untereinander verschaltet werden.

## Patentansprüche

1. Leiterplatte (1) mit wenigstens zwei Anschlussstellen (3) und wenigstens einem Präzisionswiderstand (2) zur Messung eines zwischen den Anschlussstellen (3) fließenden Stroms, wobei sich der Präzisionswiderstand (2) zwischen den Anschlussstellen (3) in der Leiterplatte (1) erstreckt und mit den Anschlussstellen (3) verschweißt ist, **dadurch gekennzeichnet, dass** wenigstens eine der Randseiten des Präzisionswiderstands (2) zumindest abschnittsweise mit Isolierstoffmasse (4) bedeckt ist und die Anschlussstellen (3) durch Ätzung aus einer auf der Oberfläche der Leiterplatte (1) befestigten Kupferfolie herausgearbeitet sind.

2. Leiterplatte (1) nach Anspruch 1, **dadurch gekennzeichnet, dass** die Leiterplatte (1) wenigstens eine Schicht aus Isolierstoffmasse (4) aufweist.

3. Leiterplatte (1) nach einem der vorangehenden Ansprüche, **dadurch gekennzeichnet, dass** auf der Leiterplatte (1) Schaltungselektronik und/oder Leistungselektronik angeordnet ist.

4. Leiterplatte (1) nach einem der vorangehenden Ansprüche, **dadurch gekennzeichnet, dass** der Präzisionswiderstand (2) zumindest überwiegend in die Leiterplatte (1) eingebettet ist.

5. Leiterplatte (1) nach einem der vorangehenden Ansprüche, **dadurch gekennzeichnet, dass** eine Oberseite des Präzisionswiderstands (2) zumindest abschnittsweise mit Isolierstoffmasse (4) bedeckt ist.

6. Leiterplatte (1) nach einem der vorangehenden Ansprüche, **dadurch gekennzeichnet, dass** eine Oberseite des Präzisionswiderstands (2) zumindest abschnittsweise bündig mit einer Oberseite einer angrenzenden Schicht aus Isolierstoffmasse (4) verläuft.

7. Leiterplatte (1) nach einem der vorangehenden Ansprüche, **dadurch gekennzeichnet, dass** die Oberseiten der Leiterplatte (1) und des Präzisionswiderstands (2) parallel zueinander ausgerichtet sind.

8. Leiterplatte (1) nach einem der vorangehenden Ansprüche, **dadurch gekennzeichnet, dass** die Leiterplatte (1) eine Spannungsmesseinrichtung (5) aufweist, die dazu ausgebildet ist, eine Spannung an den Anschlussstellen (3) zu messen.

9. Leiterplatte (1) nach einem der vorangehenden Ansprüche, **dadurch gekennzeichnet, dass** die Leiterplatte (1) eine Spannungsmesseinrichtung (5) aufweist, die eine HDI (High Density Interconnect) - Schaltung verwirklicht.

10. Verfahren zur Herstellung einer Leiterplatte (1) mit wenigstens einem sich in der Leiterplatte (1) erstreckenden Präzisionswiderstand (2) zur Messung eines zwischen Anschlussstellen (3) fließenden Stroms, umfassend die Schritte:
a. Ankontaktieren des Präzisionswiderstands (2) an den Anschlussstellen (3) und Verschweißen des Präzisionswiderstands (2) mit den Anschlussstellen (3).
b. Bedecken des Präzisionswiderstands (2) mit einer elektrischen Isolierstoffmasse (4), wobei wenigstens eine der Randseiten des Präzisionswiderstands (2) zumindest abschnittsweise mit Isolierstoffmasse (4) bedeckt wird.
c. Elektrisches Isolieren der Anschlussstellen (3) voneinander, so dass ein zwischen den Anschlussstellen (3) fließender Strom durch den Präzisionswiderstand (2) fließt, wobei die Anschlussstellen (3) durch Ätzung aus einer auf der Oberfläche der Leiterplatte (1) befestigten Kupferfolie herausgearbeitet werden.

11. Verfahren nach Anspruch 10, **gekennzeichnet durch** Verpressen des Präzisionswiderstands (2) mit einem Prepreg aus Isolierstoffmasse.

12. Verfahren nach einem der Ansprüche 10 oder 11, **gekennzeichnet durch** Herstellen einer Spannungsmesseinrichtung (5) auf der Leiterplatte und Bedecken des Präzisionswiderstands (2) mit wenigstens einer Schicht aus Isolierstoffmasse (4).

13. Verfahren nach einem der Ansprüche 10 bis 12, **gekennzeichnet durch** Herstellen einer Spannungsmesseinrichtung (5) auf der Leiterplatte und Herstellen einer Bohrung zur Ankontaktierung des Präzisionswiderstands (2) durch wenigstens eine Schicht aus Isolierstoffmasse (4).

14. Verfahren nach einem der Ansprüche 10 bis 13, **gekennzeichnet durch** Herstellen einer Spannungsmesseinrichtung (5) auf der Leiterplatte und Ankontaktieren des Präzisionswiderstands (2) durch wenigstens eine Schicht aus Isolierstoffmasse (4).

## Claims

1. Printed circuit board (1) with at least two connection points (3) and at least one precision resistor (2) for measuring a current flowing between said connection points (3), wherein said precision resistor (2) extends between said connection points (3) in said printed circuit board (1) and is welded to said connection points (3), **characterized in that** that at least one of the edge sides of said precision resistor (2) is at least partially covered with insulating material (4) and that said connection points (3) are worked out by way of etching from a copper foil attached to the surface of said printed circuit board (1).

2. Printed circuit board (1) according to claim 1, **characterized in that** said printed circuit board (1) comprises at least one layer of insulating material (4).

3. Printed circuit board (1) according to at least one of the preceding claims, **characterized in that** circuit electronics and/or power electronics are disposed on said printed circuit board (1).

4. Printed circuit board (1) according to at least one of the preceding claims, **characterized in that** said precision resistor (2) is at least predominantly embedded into said printed circuit board (1).

5. Printed circuit board (1) according to at least one of the preceding claims, **characterized in that** an upper side of said precision resistor (2) is at least partially covered with insulating material (4).

6. Printed circuit board (1) according to at least one of the preceding claims, **characterized in that** an upper side of said precision resistor (2) extends at least in sections flush with an upper side of an adjacent layer of insulating material (4).

7. Printed circuit board (1) according to at least one of the preceding claims, **characterized in that** said upper sides of said printed circuit board (1) and of said precision resistor (2) are aligned parallel to each other.

8. Printed circuit board (1) according to at least one of the preceding claims, **characterized in that** said printed circuit board (1) comprises a voltage measuring device (5) that is adapted to measure a voltage at said connection points (3).

9. Printed circuit board (1) according to at least one of the preceding claims, **characterized in that** said printed circuit board (1) comprises a voltage measuring device (5) that realizes an HDI (High Density Interconnect) circuit.

10. Method for manufacturing a printed circuit board (1) with at least one precision resistor (2) extending in said printed circuit board (1) for measuring a current flowing between connection points (3), comprising the steps of:
a. Connecting said precision resistor (2) at said connection points (3) and welding said precision resistor (2) to said connection points (3).
b. Covering said precision resistor (2) with electrically insulating material (4), wherein at least one of the edge sides of said precision resistor (2) is at least partially covered with insulating material (4).
c. Electrically insulating said connection points (3) from each other, so that a current flowing between said connection points (3) flows through said precision resistor (2), wherein said connection points (3) are worked out by way of etching from a copper foil attached to the surface of said printed circuit board (1).

11. Method according to claim 10, **characterized by** pressing a prepreg made of insulating material to said precision resistor (2).

12. Method according to claim 10 or 11, **characterized by** manufacturing a voltage measuring device (5) on said printed circuit board and covering said precision resistor (2) with at least one layer of insulating material (4).

13. Method according to any one of claims 10 to 12, **characterized by** manufacturing a voltage measuring device (5) on said printed circuit board and producing a bore for connecting said precision resistor (2) through at least one layer of insulating material (4).

14. Method according to any one of claims 10 to 13, **characterized by** manufacturing a voltage measuring device (5) on said printed circuit board and connecting said precision resistor (2) through at least one layer of insulating material (4).

## Revendications

1. Circuit imprimé (1) avec au moins deux jonctions (3) et au moins une résistance de précision (2) pour mesurer un courant entre les jonctions (3), dans lequel la résistance de précision (2) s'étend entre les jonctions (3) dans le circuit imprimé (1) et est soudée aux jonctions (3), **caractérisé en ce qu'**au moins l'un des bords de la résistance de précision (2) est recouvert au moins sur une section par une masse de matériau isolant (4), et les jonctions (3) sont produites par gravure d'une feuille de cuivre attachée à la surface du circuit imprimé (1).

2. Circuit imprimé (1) selon la revendication 1, **caractérisé en ce que** le circuit imprimé (1) comporte au moins une couche en masse de matériau isolant (4).

3. Circuit imprimé (1) selon l'une des revendications précédentes, **caractérisé en ce qu'**un dispositif électronique de commande et/ou de puissance est agencé sur le circuit imprimé (1).

4. Circuit imprimé (1) selon l'une des revendications précédentes, **caractérisé en ce que** la résistance de précision (2) est au moins principalement intégrée dans le circuit imprimé (1).

5. Circuit imprimé (1) selon l'une des revendications précédentes, **caractérisé en ce qu'**un côté supérieur de la résistance de précision (2) est recouvert au moins sur une section par une masse de matériau isolant (4).

6. Circuit imprimé (1) selon l'une des revendications précédentes, **caractérisé en ce qu'**un côté supérieur de la résistance de précision (2) se joint, au moins sur une section, de manière affleurante à un côté supérieur d'une couche adjacente en masse de matériau isolant (4).

7. Circuit imprimé (1) selon l'une des revendications précédentes, **caractérisé en ce que** les côtés supérieurs du circuit imprimé (1) et de la résistance de précision (2) sont agencés parallèlement.

8. Circuit imprimé (1) selon l'une des revendications précédentes, **caractérisé en ce que** le circuit imprimé (1) comporte un dispositif de mesure de tension (5) qui est conçu pour mesurer une tension sur les jonctions (3).

9. Circuit imprimé (1) selon l'une des revendications précédentes, **caractérisé en ce que** le circuit imprimé (1) comporte un dispositif de mesure de tension (5) qui constitue un circuit HDI (High Density Interconnect).

10. Procédé de fabrication d'un circuit imprimé (1) avec au moins une résistance de précision (2) qui s'étend dans le circuit imprimé (1) pour mesurer un courant entre les jonctions (3), comprenant les étapes suivantes :
a. mise en contact de la résistance de précision (2) avec les jonctions (3) et soudage de la résistance de précision (2) sur les jonctions (3),
b. recouvrement de la résistance de précision (2) avec une masse de matériau isolant électrique (4), dans lequel au moins l'un des bords de la résistance de précision (2) est recouvert au moins sur une section par une masse de matériau isolant (4),
c. isolation électrique des jonctions (3) entre elles de telle sorte que le courant entre les jonctions (3) passe par la résistance de précision (2), dans lequel les jonctions (3) sont produites par gravure d'une feuille de cuivre attachée à la surface du circuit imprimé (1).

11. Procédé selon la revendication 10, **caractérisé par** l'injection sous pression de la résistance de précision (2) avec un matériau préimprégné en masse de matériau isolant.

12. Procédé selon l'une des revendications 10 ou 11, **caractérisé par** la fabrication d'un dispositif de mesure de tension (5) sur le circuit imprimé et le recouvrement de la résistance de précision (2) avec au moins une couche en masse de matériau isolant (4).

13. Procédé selon l'une des revendications 10 à 12, **caractérisé par** la fabrication d'un dispositif de mesure de tension (5) sur le circuit imprimé et la réalisation d'un perçage pour la mise en contact de la résistance de précision (2) avec au moins une couche en masse de matériau isolant (4).

14. Procédé selon l'une des revendications 10 à 13, **caractérisé par** la fabrication d'un dispositif de mesure de tension (5) sur le circuit imprimé et la mise en contact de la résistance de précision (2) avec au moins une couche en masse de matériau isolant (4).
